# EUROPEAN PATENT APPLICATION

(11) **EP 3 034 655 A1**
(43) Date of publication of application: **22.06.2016**
(21) Application number: 14199374.1
(22) Date of filing: 19.12.2014
(51) Int. Cl.: C25D 7/12, C25D 3/38, C25D 5/02, C25D 5/48, C23C 18/16, C23C 18/40, H01L 21/288

(54) **Trench pattern wet chemical copper metal filling using a hard mask structure**

(71) Applicant: Atotech Deutschland GmbH, 10553 Berlin (DE)
(72) Inventor: Adolf, James, 10553 Berlin (DE); Jagannathan, Rangarajan, Hopewell Junction, New York 12533 (US); Suzuki, Hidenao, Slingerlands, New York 12159 (US); van Eisden, Jobert, 10553 Berlin (DE)
(74) Representative: Wonnemann, Jörg

(57) **Abstract**

The present invention concerns a method for electrodepositing copper into a trench pattern in a structure including the following steps: forming a patterned metal hard mask layer over the dielectric substrate layer; patterning the dielectric layer by using an etch through the patterned metal-based hardmask optionally, forming a barrier and / or liner layer over the surface of the patterned dielectric substrate layer and the hard mask layer; forming over the barrier layer and the hard mask layer a basic metal seed layer by a wet chemical plating method to provide sufficient conductance for subsequent electrolytic deposition of copper; and immersing the dielectric substrate into an electrolytic copper plating bath in an electrolytic copper plating system to electrodeposit copper into the patterned dielectric substrate layer. The hard mask only needs to be removed after copper deposition.

## Description

### Field of the Invention

The present invention relates to a method for electrodepositing copper into a trench pattern including the steps of forming an etch hard mask, etching a trench and/or via pattern into the underlying material, providing a copper seed layer by wet chemical plating methods and electrolytic metal deposition to fill the trench and/or via pattern. The method according to the present invention is particularly suitable for dual damascene and TSV (through silicon via) plating in the manufacture of microchips and the like.

### Background of the Invention

The present invention relates to a semiconductor structure and method for semiconductor fabrication. More specifically the present invention relates to a semiconductor structure and method of semiconductor fabrication for improving electrolytic copper deposition to fill the trench pattern.

The process steps typically involve pattern and etch of the trench features into the metal hard mask followed by an etching step to transfer the pattern into the underlying material.

In semiconductor manufacturing, Back End of the Line (BEOL) copper interconnect scaling uses a Trench First Metal Hard Mask (TFMHM) process to maintain pattern fidelity and control during the manufacturing process, for example, from lithography to plasma etch. One motivation known in the art and described in US patent number 8,796,150 B2 for selecting the Trench First Hard Mask (TFHM) is to eliminate a pass of oxygen type plasma ash that leads to low-k dielectric damage found both in line (trench) sidewalls as well as in vias. A low-k dielectric material has a lower dielectric constant than silicon dioxide. During processing, a metal hard mask may include a titanium nitride (TiN) film deposited on top of a dielectric hard mask film. Lithographic patterns may be formed on top of the TiN film using organic-containing films. However, undesirable consequences to the trenches of an interconnect structure can occur during the above or subsequent processing. Thus, TFHM integration results in new challenges with respect to a metal hard mask (e.g. TiN) erosion and interaction with plasma during both lithographic rework and dual damascene etching. For example, during a typical rework process, plasma chemistries can both modify the surface and reduce the TiN film thickness which subsequently leads to a wider critical dimension during a dual damascene etch process step during interconnect processing. Consequently, this results in an undesirable increase in the non-uniformity across a wafer diameter. Moreover, long process queue times between TiN deposition and lithography may occur, and thus, the metallic TiN film forms undesirable native oxides that affect lithography and react with fluorocarbon plasma in such a manner that the control of critical dimension uniformity (CD) of features across the wafer becomes more difficult. Additionally, these mechanisms can create physical defects which affect the overall pattern fidelity.

Plasma etch of the multilayer dielectric stack challenges the etch unit processes in maintaining the etch selectivity between the different layers, while simultaneously producing acceptable profiles of the resultant via and trench features.

In order to address the downstream process compatibility, dual damascene features fabricated in low-k dielectric materials may contain sacrificial layers, such as dielectric or metal hard masks, which used to remain in place prior to metallisation and are removed only after metallisation during the chemical-mechanical polishing of copper. However, the trend towards high aspect ratios in trench patterns makes this hitherto used method more and more difficult. The high aspect ratios are further increased by the presence of sacrificial layers in the dual damascene flow (e.g. hard masks) and challenge the capability of the physical vapour deposition process in providing continuous conformal deposition.

In order to overcome the line-of-sight limitations of physical vapour deposition, alternative approaches such as resputtering of the barrier and liner layer are utilised to improve the coverage of the barrier and liner layers on the side walls of the vias and trenches. A continuous seed with good adhesion is necessary to ensure complete filling of the electroplated copper into the dual damascene features.

It would therefore be desirable to provide method for pattern filling with copper which is reliable and does not require removal of the hard mask prior to the metallisation step.

### Summary of the Invention

This objective is solved by a method for electrodepositing copper into a trench pattern in a structure, comprising the following steps
(i) providing a substrate, said substrate comprising a substrate layer;
(ii) forming a metal hard mask layer over the patterned substrate layer;
(iii) optionally, forming a barrier and / or liner layer over the surface of the patterned substrate layer and the hard mask layer, wherein the barrier layer inhibits diffusion of copper into the dielectric layers comprising the structure, and the liner layer promotes adhesion between the seed layer and the underlying layer;
(iv) forming over the hard mask layer and the optional barrier layer and / or liner layer a basic metal seed layer by a wet chemical plating method to provide sufficient conductance for subsequent electrolytic deposition of copper or a copper alloy;
(v) immersing the substrate into an electrolytic copper or copper alloy plating bath in an electrolytic copper plating system with the basic metal seed layer connected as a cathode, the system further comprising a source of copper metal and an anode; and applying an electrical voltage between the anode and the basic metal seed layer, so that the current flows therebetween for a time sufficient to electrodeposit copper into the patterned substrate layer;
(vi) removing the hard mask including removing electrodeposited copper deposited onto the hard mask.

### Brief Description of the Figures

Figure 1 shows a method for copper filling of trench patterns according to a method of the prior art.
Figure 2 shows a method for copper filling of trench patterns according to a method of the invention which includes electroless deposition of a conformal and thin copper seed layer.

### Detailed Description of the Invention

The substrate material suitable for the method according to the present invention is preferably selected from silicon, a low-k dielectric material on a silicon substrate and glass. Electronic devices made of such materials com-prise microchips, glass interposers and the like. Recessed structures in such substrate materials need to be coated or filled with a metal which is usually deposited by electroplating. The most relevant metal is electroplated copper.

One particular application of the method according to the present invention is electroplating a metal into very fine recessed structures etched into a silicon substrate or a low-k dielectric material on a silicon substrate. Typical low-k dielectric materials are known in the art and comprise fluorine-doped silicon dioxide, carbon-doped silicon dioxide, porous silicon dioxide, porous carbon-doped silicon dioxide, polyimide, polynorbornenes, benzocyclobutane, PTFE and spin-on silicone based polymeric dielectrics such as hydrogen-silsesquioxane and methyl-silsesquioxane.

Such very fine recessed structures can be blind vias (only having one opening), through vias (having an opening on both sides of the substrate) as well as trenches (line patterns and the like). Such recessed structures usually have geometric dimensions ranging from e.g. 5 nm or 10 nm to several hundred µm or even mm.

Typical applications are dual damascene applications wherein the recessed structures are formed in silicon and/or a low-k dielectric material and having an opening size in the nanometer or low micrometer range. The copper seed layer may have a thickness in the range of 1 to 200 nm, preferably up to 20 nm.

Another application is filling of through silicon vias (TSVs) which are blind vias in silicon and/or a low-k dielectric material on a silicon substrate. The opening of TSVs is typically in the micrometer range and the copper seed layer may have a thickness up to several hundred nanometers or even one or more micrometer.

All of these applications require a homogeneous thickness distribution of the copper seed layer and a smooth outer surface.

The method according to the present invention is particularly advantageous for structures having a high aspect ratio, i.e. a depth to width aspect ratio of at least 3 to 1, more preferably 10 to 1 and even more preferably up to 100 to 1.

Undesired diffusion and related processes of said electroplated metal into the substrate material or vice versa must be suppressed in many cases in order to obtain and/or maintain the desired properties of the final electronic device. Accordingly, the electroplated metal is separated by means of one or more barrier layers deposited by either gas phase methods such as chemical vapour deposition (CVD), physical vapour deposition (PVD) and atomic layer deposition (ALD) and plasma-enhanced methods of the aforementioned, or wet chemical processes such as electroless plating. Only the most outer barrier layer in case of a stack of two or more individual barrier layer materials will be in contact with the electroless copper plating bath. The single barrier layer material or most outer barrier layer material in case of stacks of two or more individual barrier layers is selected from cobalt, nickel, ruthenium, tungsten, molybdenum, tantalum, titanium, iridium, rhodium and alloys of the aforementioned.

Said "alloys of the aforementioned" comprises nitrides such as tungsten nitride, tantalum nitride and cobalt nitrides such as Co₄N as well as phosphides and borides such as cobalt- and nickel-phosphorous or -boron alloys, ternary cobalt- and nickel-phosphorous alloys and ternary cobalt- and nickel-boron alloys (e.g. Ni-Mo-P, Ni-W-P, Co-Mo-P, Co-W-P, Co-W-B).

The thickness of said barrier layer or the outermost barrier layer in case of a stack of several barrier layers usually has a thickness in the range of 1 to 20 nm.

Metal hard mask is currently used during the creation of small interconnect features in semiconductor manufacture. Historically, the metal hard mask would remain in place during the etch step, the deposition of the optional barrier and liner layer and the seed layer and the electrolytic copper plating step, and then be removed during CMP (chemical mechanical polishing). In new generations of semiconductor features, however, the metal hard mask must be removed after the etch step and before the deposition of barri-er/liner/seed, due primarily to issues with acceptable coverage of PVD (Physical Vapour Deposition) copper as seed. The removal of the metal hard mask as an additional step before interconnect metallization is not desired.

As the interconnect geometries scale into the sub-100-nm regime, the thickness of the copper seed deposited in these features also needs to be scaled down to prevent pinch-off prior to the electrodeposition step. Electroplating on thin copper seeds with relatively high sheet resistance is challenged by the terminal effect in the plating cell, whereby the voltage drop across the semiconductor substrate diameter induces a large non-uniformity in the electroplated layer thickness and may also lead to voiding within the features.

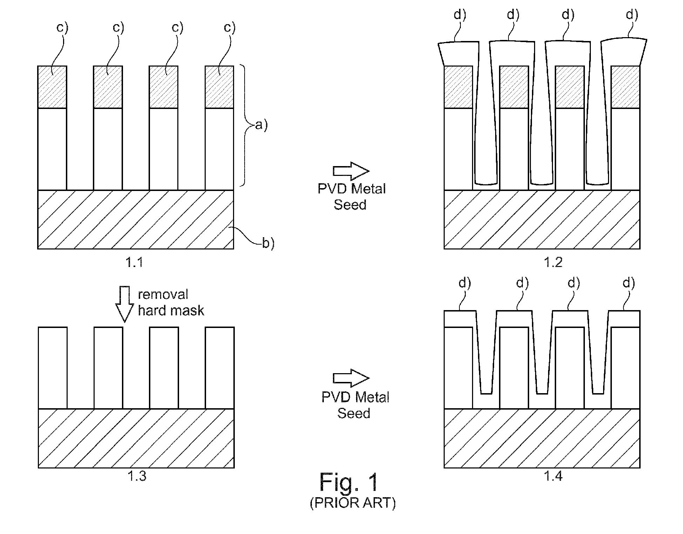

This is shown in Figure **1.** Figure **1.1** shows a trench pattern comprising a patterned dielectric substrate layer (a) and a dielectric layer (b) with hard mask layers (c) over the patterned dielectric substrate layers. Figure **1****.****2** is a depiction of a copper seed (d) deposited by PVD. As becomes apparent, the openings at the top of the trench patterns are relatively small. This results in incomplete bottom-up filling, the risk of voids and pinch-off before the features are completely filled with copper by electrolytic deposition techniques.

For this reason, when using PVD techniques to create a copper seed layer, the metal hard mask needs to be removed (Figure **1.3**) prior to the formation of the seed layer (Figure **1.4**) in order to reduce the aspect ratio and ensure a seed layer having suitable openings for complete electrolytic copper filling. This extra step of hard mask removal is not desired, particularly since it might result in damage of the substrate material, particularly when a low-k material is used, which is prone to mechanical damage during the hard mask removal.

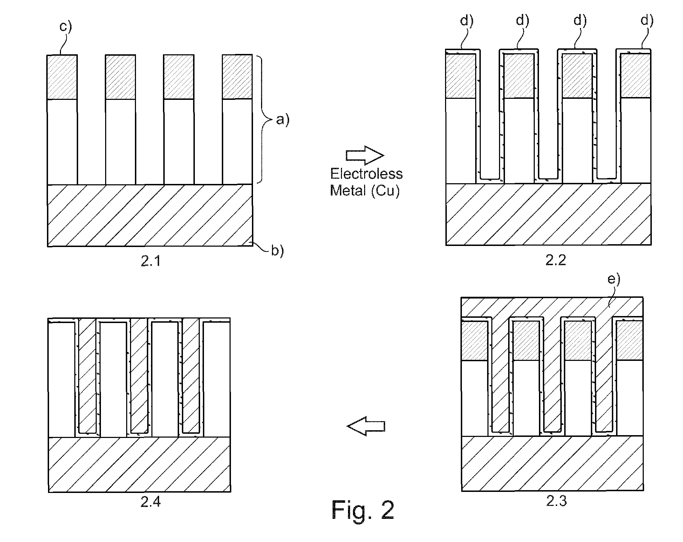

Electroless copper deposited by a wet chemical plating process, unlike PVD deposited copper, is not a directional process, and can deposit conformal layers (Figure **2**) on the higher aspect ratio and/or misshaped features caused by use of a metal hard mask.

Figure **2****.****1** shows a trench pattern comprising a patterned dielectric substrate layer (a) and a dielectric layer (b) with hard mask layers (c) over the patterned dielectric substrate layers. The dielectric layer can additionally and optionally be provided with a barrier layer and / or liner layer (not shown). The use of and nature of such layers is well known to the person skilled in the art. The barrier layer inhibits diffusion of copper into the dielectric layers comprising the structure, and the liner layer promotes adhesion between the seed layer and the underlying layer.

Figure **2.2** is a depiction of a copper seed (d) deposited by in electroless metallisation step according to the method of the present invention. As can be seen from Figure **2.2** a thin seed layer (d) having a homogeneous thickness distribution can be deposited over the entire surface leaving a sufficiently large opening for subsequent electrolytic metal, preferably copper deposition (e). Therefore, the metal hard mask removal step can be omitted prior to metallization (shown in Figure 2.3), allowing for easier integration.

Additionally, as features get smaller and very thin seed layers are required (such as electroless copper), the sheet resistance of the semiconductor substrate can rise significantly. This leads to increased terminal effect, which can cause issues with the uniformity of electrodeposition. Terminal effect denotes the fact that due to uneven current density distribution across the wafer surface, features in the wafer center will be metal plated and filled at a different (lower) current density than features at the wafer edge. This can result in undesired voids and inclusions. Currently, terminal effect is managed by the use of a low acidity plating solution and tool designs such as thief electrodes or segmented anodes. Generally, a sheet resistivity of about 50 - 100 ohm/cm² is desired, but a very thin copper seed without a metal hard mask can have sheet resistivity significantly higher than this.

Preferably, the seed layer according to the present invention is a copper or copper alloy seed layer. Preferably, the seed layer according to the present invention has a thickness of less than 20 nm, e.g. ranges between 1 and 10 nm or 2 and 5 nm.

The hard mask according to the present invention can consist of one or more layers. The hard mask according to the present invention comprises at least one conductive metal-based hard mask layer to provide for the desired low sheet resistivity. Metal-based within the meaning of this invention defines a material which is metal comprising. Preferably, the at least one metal-based hard mask layer according to the present invention is in direct contact with the patterned dielectric substrate layer. Typical materials for the metal-based hard mask layer comprise Co, TaN, Ta, Ti, TiN, Ru, Ir, Au, Rh, Pt, Pd or Ag. Alloys of such materials are also suitable.

The metal-based hard mask layer may be formed utilizing any conventional deposition process including, for example, CVD, PECVD, chemical solution deposition, evaporation, metal organic deposition, ALD, sputtering, PVD or plating (electroless or electrolytic). The thickness of the metal layers may vary depending on the exact metallic interfacial material used as well as the deposition technique that was used in forming the same. Typically, the metal hard mask layer has a thickness from about 2 to about 200 nm, with a thickness from about 5 to about 100 nm being preferred, and a thickness from about 10 to 60 nm being particularly preferred.

The metal hard mask can optionally contain additional layers, e.g. dielectric layers, which include an oxide, nitride, epoxynitride or a combination thereof. Suitable dielectric hard mask material is an oxide like SiO₂ or a nitride such as Si₃N₄. The hard mask material is formed utilizing a conventional deposition process such as, for example, CVD, PECVD, chemical solution deposition or evaporation. The thickness of the as-deposited hard mask material may vary depending upon the type of hard mask material formed, the number of layers that make up the hard mask material and the deposition technique used in forming the same. Typically, the as-deposited hard mask material has a thickness from about 2 to about 100 nm, with a thickness from about 10 to about 60 nm being even more typical.

The issue of resistivity can be mitigated by tool design, but an additional benefit of retaining the metal hard mask during plating is that is decreases the sheet resistance of the wafer, allowing for easier control of electrolytic copper plating uniformity. This is an additional advantage of the present invention.

In one embodiment of the invention the hard mask remains in place prior to the copper filling of the trench pattern or the barrier / liner / metal seed deposition process. In an alternative embodiment the hard mask is only partially removed prior to the copper filling of the trench pattern or the barrier / liner / metal seed deposition process. Partial removal can result in better seed coverage, while keeping the advantage of a higher total conductivity for the electrolytic copper filling process of the trench pattern. If the hard mask comprises more than one layer, preferably the metal hard mask portion remains in place prior to deposition of the metal seed layer to provide for the desired low resistivity. Alternatively, a defined portion of the hard mask may be removed, depending on the feature size of the trench pattern. Removal of a portion of the hard mask means that a portion of the layer corresponding to for example 20%, 30% or up to 60 or 70% of the original layer thickness is removed, 100% corresponding to complete removal.

The copper seed layer is deposited by electroless plating onto the barrier and / or liner layer. In case no barrier layer is applied to the substrate material, the copper seed layer is directly deposited onto the dielectric material. In the latter case, the deposition of the copper seed layer includes deposition together with a second metal which acts as a barrier metal. The deposition of at least one barrier layer before applying the copper seed layer is preferred.

"Electroless plating" means "autocatalytic plating". Hence, the copper plating bath utilized in step (ii) comprises a reducing agent for Cu(II) ions.

The electroless copper plating bath utilized in the method according to the present invention is preferably an aqueous plating bath, i.e., the solvent is water.

The water-soluble source for Cu(II) ions is preferably selected from the group comprising copper sulfate, copper chloride, copper nitrate, copper acetate, copper methane sulfonate, copper hydroxide, copper formate and hydrates thereof. The concentration of Cu(II) ions in the electroless plating bath preferably ranges from 0.05 to 20 g/l, more preferably from 0.1 to 10 g/l and most preferably from 0.2 to 6 g/l.

The electroless plating bath further contains a reducing agent selected from the group comprising formaldehyde, glyoxylic acid, glucose, sucrose, cellulose, sorbitol, mannitol, gluconolactone, hypophosphite, boranes, hydrazine, formic acid, ascorbic acid and mixtures thereof. Most preferably, the reducing agent is glyoxylic acid. The concentration of the reducing agent preferably ranges from 0.1 to 100 g/l, more preferably from 0.5 to 50 g/l and most preferably from 1 to 20 g/l.

The electroless plating bath further comprises at least one complexing agent for Cu(II) ions which is preferably selected from the group comprising carboxylic acids, hydroxycarboxylic acids, aminocarboxylic acids, alkanolamines, polyols and mixtures thereof.

The electroless plating bath is preferably held at a temperature in the range of 15 to 80 °C, more preferably 20 to 60°C and most preferably 25 to 45 °C. The substrate is contacted with the electroless plating bath for 5 s to 30 min, depending on the desired thickness of the copper seed layer to be deposited and on the plating rate obtained by the particular plating bath composition and plating parameters.

The copper seed layer has a homogeneous thickness distribution even at a thickness of e.g. 10 nm or even less. Hence, the barrier layer is completely covered by the copper seed layer even if the copper seed layer only has a thickness of e.g. 10 nm or even less.

The substrate is then suited for depositing a metal onto the copper seed layer by electroplating.

The metal which is deposited by electroplating onto the copper seed layer as shown in Figure **2.3** is copper or a copper alloy. Suitable bath compositions and plating conditions for depositing copper or copper alloys onto the copper seed layer are known in the art.

Besides containing at least one copper ion source, preferably a copper salt with an inorganic or organic anion, for example copper sulfate, copper methane sulfonate, copper pyrophosphate, copper fluoroborate or copper sulfamate, the bath used for the copper electrodeposition additionally contains at least one substance for increasing the electrical conductance of the bath, for example sulfuric acid, methane sulfonic acid, pyrophosphoric acid, fluoroboric acid or amidosulfuric acid.

In one embodiment, in the electrolytic bath the acid is sulfuric acid at a bath concentration in the range from about 50 to about 350 g/l, or from about 180 g/l to about 280 g/l, or from about 100 g/l to about 250 g/l, or from about 50 g/l to about 90 g/l, the source of copper ions is copper sulfate pentahydrate at a bath concentration in the range from about 5 g/l to about 250 g/l, or from about 80 g/l to about 140 g/l, or from about 180 g/l to about 220 g/l.

The electroplating bath according to the invention generally contains at least one additive compound for controlling the physical-mechanical properties of the copper layers. Suitable additive compounds are, for example, polymeric oxygen-containing compounds, organic sulfur compounds, thiourea compounds, polymeric phenazonium compounds and polymeric nitrogen compounds, and mixtures or combinations of any two or more of any of these additive compounds.

For the electrolytic copper deposition of the present invention, a voltage is applied between the substrate and the anode, the voltage being so selected that an electric current of 0.05 amps per dm² (A/dm²) to 20 A/dm², in one embodiment, 0.2 A/dm² to 10 A/dm² and, in another embodiment, 0.5 A/dm² to 5 A/dm², where the current flows are expressed as amps per dm² of, e.g., semiconductor substrate surface, assuming that the plating is applied to the entire surface of the substrate.

In one embodiment, the electrical voltage is applied in a pulse current or a pulse voltage. In one embodiment, the electrical voltage is applied in a reverse pulse form with bipolar pulses. These processes are well known in the art, and detailed parameters for use with some embodiments of the present invention are described in more detail in the following.

In one embodiment, the electrical voltage is applied in a reverse pulse form with bipolar pulses including a forward current pulse and a reverse current pulse. In one embodiment, the duration of the reverse current pulse is adjusted to about 1 to about 20 milliseconds, and in another embodiment, the duration of the reverse current pulse is adjusted to about 2 to about 10 milliseconds. In one embodiment, the duration of the forward current pulse is adjusted to about 10 to about 200 milliseconds, and in another embodiment, the duration of the forward current pulse is adjusted to about 20 to about 100 milliseconds.

In one embodiment, peak current density of the forward current pulse at the substrate surface is adjusted to maximum of about 15 amps per square decimeter (A/dm²), and in another embodiment, peak current density of the forward current pulse at the substrate surface is adjusted to a maximum of about 1.5 to about 8 A/dm². In one embodiment, the peak current density of the reverse current pulse at the substrate surface is adjusted to a maximum of about 60 A/dm², and in another embodiment, peak current density of the reverse current pulse at the substrate surface is adjusted to a maximum of about 30 to about 50 A/dm².

In one embodiment, a cathodic current pulse is shifted with respect to an anodic current pulse. A pause of suitable duration may be included between the first current pulse and the second current pulse. A suitable duration may range, for example, from about 1 millisecond to about 5 milliseconds, and in one embodiment is from about 2 milliseconds to about 4 milliseconds, and in one embodiment, is about 4 milliseconds.

After the electrolytic copper deposition further processing follows which includes removal of the overburden copper, (if present) the optional liner layer, the optional barrier layer and the hard mask (shown in Figure **2.4**)**.** It is an advantage of the present invention that the hard mask only needs to be removed after copper deposition. These methods are well known in the art. The treatment includes thinning. The thinning may be carried out by any known method.

Copper can be removed according to standard procedures. The copper layer can simply be removed, e.g. by CMP, or it can be patterned to create an electrical circuit on that surface of a semiconductor substrate.

## Claims

1. A method for electrodepositing copper into a trench pattern in a structure, comprising the following steps
(vii) providing a substrate, said substrate comprising a substrate layer;
(viii) forming a metal hard mask layer over the patterned substrate layer;
(ix) optionally, forming a barrier and / or liner layer over the surface of the patterned substrate layer and the hard mask layer, wherein the barrier layer inhibits diffusion of copper into the dielectric layers comprising the structure, and the liner layer promotes adhesion between the seed layer and the underlying layer;
(x) forming over the hard mask layer and the optional barrier layer and / or liner layer a basic metal seed layer by a wet chemical plating method to provide sufficient conductance for subsequent electrolytic deposition of copper or a copper alloy;
(xi) immersing the substrate into an electrolytic copper or copper alloy plating bath in an electrolytic copper plating system with the basic metal seed layer connected as a cathode, the system further comprising a source of copper metal and an anode; and applying an electrical voltage between the anode and the basic metal seed layer, so that the current flows therebetween for a time sufficient to electrodeposit copper into the patterned substrate layer;
(xii) removing the hard mask including removing electrodeposited copper deposited onto the hard mask.

2. The method of claim 1, wherein the patterned dielectric substrate layer comprises trenches and vias having a dimension of 5 nm to 1 mm.

3. The method of any of the foregoing claims wherein the basic metal seed layer is a copper layer having a thickness of 1 to 10 nm.

4. The method of any of the foregoing claims, wherein the dielectric substrate is selected from the group consisting of silicon, silicon dioxide and a low-k dielectric material on a silicon substrate.

5. The method of any of the foregoing claims, wherein the step of forming a metal hard mask layer includes forming a TiN hard mask layer.

6. The method of any of the foregoing claims, wherein the step of removing the hard mask layer includes chemical mechanical polishing and / or etching.

7. The method of any of the foregoing claims, wherein the wet chemical plating method to provide a basic metal seed layer according to step (iv) is an aqueous copper plating method.

8. The method of claim 7, wherein the aqueous copper plating method comprises the following step:
contacting said dielectric substrate with an aqueous electroless copper plating bath which comprises
a. a water-soluble source for Cu(II) ions,
b. a reducing agent for Cu(II) ions,
c. at least one complexing agent for Cu(II) ions.

9. The method of claim 8, wherein the reducing agent in the electroless copper plating bath is selected from the group consisting of formaldehyde, glyoxylic acid, glucose, sucrose, cellulose, sorbitol, mannitol, gluconolactone, hypophosphite, boranes, hydrazine, formic acid, ascorbic acid and mixtures thereof.

10. The method of claims 8 and 9, wherein the complexing agent for Cu(II) ions in the electroless copper plating bath is selected from the group consisting of carboxylic acids, hydroxycarboxylic acids, aminocarboxylic acids, alkanolamines, polyols and mixtures thereof.

11. The method of claims 8 to 10, wherein the water-soluble source for Cu(II) ions is selected from the group comprising copper sulfate, copper chloride, copper nitrate, copper acetate, copper methane sulfonate, copper hydroxide, copper formate and hydrates thereof.

12. The method of any of the foregoing claims, wherein the electrolytic copper plating bath according to step (v) comprises sulfuric acid at a concentration in the range from 50 to 350 g/l, a source of copper ions resulting in a concentration of copper ions in the range from about 5 to about 250 g/l, and at least one additive for controlling physical-mechanical properties of the deposited copper comprising one or more of a polymeric oxygen-containing compound, an organic sulfur compound, a thiourea compound and a polymeric phenazonium compound.

13. The method of any one of the foregoing claims, wherein the electrical voltage is applied in a pulse current or a pulse voltage.

14. The method of claim 13, wherein the electrical voltage is applied in a reverse pulse form with bipolar pulses including a forward current pulse and a reverse current pulse.

15. The method of claims 13 or 14, wherein the duration of the reverse current pulse is adjusted to 1 to 20 milliseconds and wherein the duration of the forward current pulse is adjusted to 10 to 200 milliseconds.
